# EUROPEAN PATENT APPLICATION

(11) **EP 3 650 488 A1**
(43) Date of publication of application: **13.05.2020**
(21) Application number: 18205312.4
(22) Date of filing: 09.11.2018
(51) Int. Cl.: C08J 5/18, B32B 17/10, C08L 29/14

(54) **METHOD FOR PRODUCING FILMS BASED ON PLASTICIZED POLYVINYL ACETAL HAVING A PREDEFINED VISCOSITY BY MOLAR MASS ADJUSTMENT**

(71) Applicant: Kuraray Europe GmbH, 65795 Hattersheim (DE)
(72) Inventor: HäRTH, Michael, 53840 Troisdorf (DE); WENZLIK, Daniel, 65207 Wiesbaden (DE)
(74) Representative: Janßen, Christian Oliver

(57) **Abstract**

The invention is directed to a process to extrude a melt stream at 150 - 250°C comprising at least one polyvinyl acetal and at least one plasticizer having a predefined melt viscosity at 60 - 170°C **characterized by**
e) providing a first melt stream comprising at least a first plasticizer and a first polyvinyl acetal resin and measuring online its melt viscosity at 60 - 170°C;
f) adding a crosslinker and/or a molar mass reducing agent to the first melt stream in an amount to provide a second melt stream with a melt viscosity at 60 - 170°C having a difference of at most 20% to the predefined melt viscosity at 60 - 170°C.

## Description

### Technical Field

The present invention relates to a method to produce films based on plasticized polyvinyl acetal by extrusion with loop-back online melt viscosity control by adjusting the molar mass of the plasticized polyvinyl acetal.

It is long known in various variants to produce interlayer films based on plasticized polyvinyl acetal by extrusion. Common for these extrusion processes is that a melt comprising plasticized polyvinyl acetal, usually plasticized polyvinylbutyral, is extruded through a thin die to produce a melt film. The shape of this melt film is then fixed or "frozen" by cooling in air and/or water. The melt temperature during the extrusion process is generally in a range of 150 - 250 °C

For producing a glass laminate, the thus produced film is placed between glass sheets to produce a stack which is then subjected to elevated temperature and pressure. During or before the lamination process, air is either removed from stack by pressure or physically dissolved in the PVB film. This so called de-airing process can be imparted by PVB film having a too high viscosity under lamination conditions resulting in visible air pockets, especially in the edge regions of the laminate. Glass laminates with visible air pockets will not be accepted by a costumer and need to be discarded.

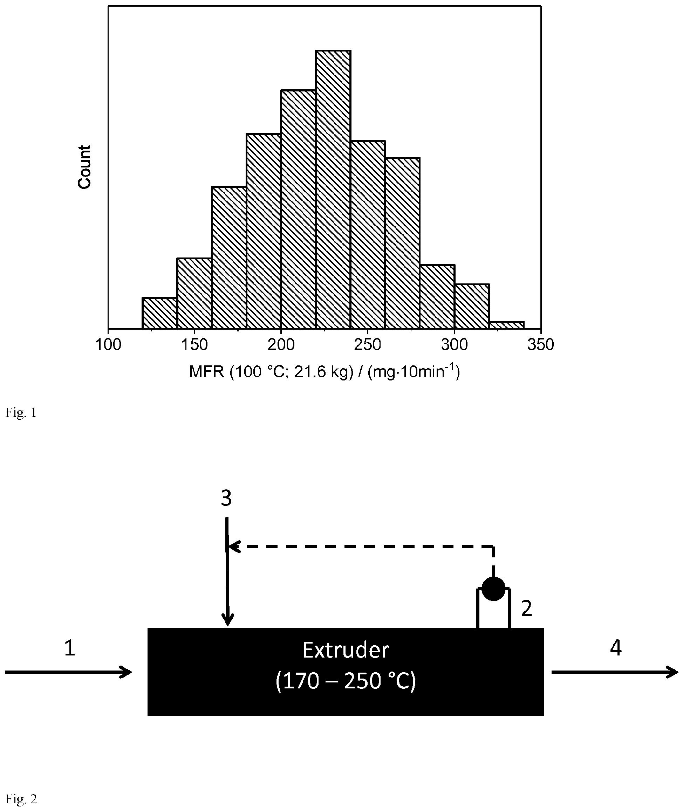

Since the chemistry and therefore the viscosity of polyvinyl acetal resin varies within certain ranges, the melt viscosity under lamination conditions of the extruded plasticised polyvinyl acetal varies too. For example, Fig. 1 shows a Gaussian distribution of MFR values, measured at 100 °C with 21.6 kg, of plasticised polyvinyl acetal resin. Accordingly, the films will have a similar distribution of mechanical properties and a similar distribution of lamination properties (i.e. melt viscosity under lamination conditions).

In order to adjust the viscosity level or to narrow the viscosity distribution, it is feasible to mix two polyvinyl acetal grades with different molar mass and/or branching architecture and/or different amounts of plasticizer. An example for the adjustment of the viscosity level is e.g. given in US2014/0275390. Here it is shown, how the weight average molar mass and therefore the viscosity can be reduced by using hydrogen peroxide as an reactive agent during extrusion.

However, the adjustment of the viscosity during extrusion on a predefined level is very time-consuming, as one has to measure the flow behavior of the resin before the extrusion process and based on the results of this measurement one has to calculate the amount of the added polyvinyl acetal with a different molar mass and/or branching architecture, the amount of the plasticizer and/or the amount of the reactive agent. Furthermore, meticulous rheological measurements e.g. with rheometer in oscillation or dynamic mode, capillary rheometer or simplest with an MFR equipment, typically require a specific specimen preparation as e.g. moisture content significantly influences the results. This procedure requires long preparations times, which is cumbersome for a continuous extrusion process.

Beside rheological measurements one could think about using specific extrusion parameters like melt pressure to calculate the required amount of one or more of the above-named components in order to adjust the viscosity. However, it was found that the melt viscosity under lamination conditions i.e. in a temperature range of 60 to 160 °C cannot be predicted from the melt viscosity or from any related process parameter at extrusion temperatures i.e. in a temperature range of 150 to 250 °C by the well-known time-temperature superposition principle, indicating that polyvinyl acetal resins show a so-called complex thermo-rheological behaviour.

Obviously, there is a need to provide a method to control the melt viscosity at lamination temperatures of 60 to 170 °C, preferable of 80 - 150°C during film extrusion process of plasticised polyvinyl acetal at temperatures between 150 and 250 °C, preferable between 170 and 250 °C.

Object of the invention was to provide an extrusion process for plasticised polyvinyl acetal film wherein the viscosity of the film can be adjusted by measuring the viscosity of the melt at lamination temperatures.

### Object of the invention

The invention therefore relates to a process to extrude a melt stream at 150 - 250°C, preferable at 170 - 250°C comprising at least one polyvinyl acetal and at least one plasticizer having a predefined melt viscosity at 60 - 170°C, preferable at 80 - 150°C **characterized by**
a) providing a first melt stream comprising at least a first plasticizer and a first polyvinyl acetal resin and measuring online its melt viscosity at 60 - 170°C, preferable at 80 - 150°C;
b) adding a crosslinker and/or a molar mass reducing agent to the first melt stream in an amount to provide a second melt stream with a melt viscosity at 60 - 170°C, preferable at 80 - 150°C having a difference of at most 20% to the predefined melt viscosity at 60 - 170°C, having a difference of at most 10% to the predefined melt viscosity at at 80 - 150°C.

The crosslinker and/or a molar mass reducing agent may be added in pure form or preferred in form of a solution or dispersion. Preferred, the crosslinker and/or a molar mass reducing agent are added as solution or dispersion in a mixture of the first plasticizer and/or the first polyvinyl acetal resin. Most preferred, the crosslinker and/or a molar mass reducing agent are added as solution or dispersion in a mixture of the first plasticizer and the first polyvinyl acetal resin having an identical composition as the first melt stream.

The predefined melt viscosity, measured e.g. as an MFR value at 60 or 80 °C and 21.6 kg is typically in the range of 1 mg/10min to 500 mg/10min and at 150 or 170 °C measured with 10 kg of 0.1 g/10min to 20 g/10min.

The melt viscosity at 80 - 150°C can be measured as melt flow rate (MFR), melt volume rate (MVR), rheometry in osziallation, dynamic or creep mode, or capillary rheometry. In a preferred execution the viscosity is measured as MFR/MVR or by a capillary rheometer.

### Brief description of the drawings

Fig. 1 shows a typical distribution of MFR values measured at 100 °C with 21.6 kg.
Fig. 2 gives an overview of the process of the invention. 1) melt stream comprising at least a first plasticizer and a first polyvinyl acetal resin; 2) measurement equipment for melt viscosity measurements at 80 - 150 °C; 3) addition of the crosslinker and/or a molar mass reducing agent stream; 4) mixture of components of 1) and 3) leading to melt stream with predefined viscosity at 80 - 150 °C

### Detailed description

The melt viscosity can be measured by commercially available online Rheometer. In the process of the invention, a small side stream is diverted from the main stream and feed into a capillary die (circular or slit) of a rheometer by a gear pump. This gear pump enables controlled and constant flow volume of the melt. A second gear pump beyond the capillary die conveys the polymer melt back to the main stream. By using more than one side stream or by changing the revolution speed of the gear pump various shear rates can be obtained. This enables the construction of a shear rate dependent viscosity curve.

In a variation of the process, the small side stream is heated to a lower temperature than the mass temperature in the extruder, which enables viscosity measurements at lamination temperatures.

Specific rheological parameter, that can be measured with online rheometer might be MFR, MVR, pressure, shear viscosity, flow rate ratio MFR (weight 1)/ MFR (weight 2), flow exponent.

Preferable, the crosslinker and/or a molar mass reducing agent resin is added to the melt stream in a iterative process to reach the predefined melt viscosity.

It is not necessary to subject the entire first melt stream to the measurement of the melt viscosity at 60 - 170 °C or 80 - 150°C. In a first embodiment, the first melt stream is heated to a temperature of 150 - 250°C or 170 - 250°C and a part of the first melt stream is separated and cooled to 60 - 170°C or 80 - 150°C for measuring its melt viscosity at 60 - 170 °C or 80 - 150°C.

Preferably, the crosslinker and/or a molar mass reducing agent is added to the melt stream upstream of the separation of the part of the first melt stream. While it is possible to discharge the separated melt stream, in order to use all material for the extrusion process, the separated melt stream may be combined with the first melt stream after measuring its melt viscosity at 60 - 170 °C or 80 - 150°C.

The crosslinker used in the process of the invention may be any compound known to the skilled person which is able to react with the polyvinyl acetal polymer, for example isocyanates. Such isocyanates may have a polymeric backbone of more than 100 carbon atoms and may contain carbon, nitrogen, oxygen and/or sulfur atoms. They may have linear, branched, cyclic, aliphatic and aromatic side groups and at least one reactive group directly linked to the polymer backbone.

Suitable croslinkers may be selected from the group consisting of hexamethylene diisocyanate, 4,4'-Methylenebis(phenyl isocyanate), Dimethyl oxalate, tolylene 2,4-diisocyanate terminated Poly(propylene glycol).

The molar mass reducing agent used in the process of the invention may be any compound known to the skilled person which is able to cleave the polyvinyl acetal polymer, for example oxidizers. Suitable oxidizers are inorganic peroxides or perhalogenic acids like 3-Chloroperbenzoic acid, perchloric acid or perchlorates (as free acid or in form of their inorganic or organic salts).

The crosslinker and/or a molar mass reducing agent may be added to the first melt during at any point of the process, i.e. upstream of the extruder or into the extruder, or even downstream of the extruder provided that a sufficient mixing of the components is ensured.

Another object of the invention was to provide an extrusion process for films comprising more than one layer of plasticised polyvinyl acetal wherein the viscosity of at least one layer can be adjusted by measuring the viscosity of the melt at lamination temperatures.

It should be noted that the number of melt streams is not limited, but in praxis three, four or five layers a coextruded into one final film.

In one embodiment of the process of the invention, at least two melt streams having different compositions are extruded in contact with each other and wherein at least one melt stream is provided with a predefined melt viscosity at 60 - 170°C according to steps a) and b).

In another embodiment of the process of the invention, three melt streams are extruded in contact with each other, wherein the outer melt streams are provided with a predefined melt viscosity at 60 - 170°C according to steps a) and b).

In another embodiment of the process of the invention, three melt streams are extruded in contact with each other, wherein the inner melt stream is provided with a predefined melt viscosity at 60 - 170°C according to steps a) and b).

In another embodiment of the process of the invention, three melt streams are extruded in contact with each other, wherein the melt streams are provided with the same or different predefined melt viscosity at 60 - 170°C according to steps a) and b).

In these embodiments, the layers may have the same of a different composition in terms of chemical nature and amount of the Polyvinylacetal and plasticizer. In a preferred variant, three layers are coextruded, wherein the outer layers have the same composition and the inner layer has a different composition as the outer layers.

### Polyvinyl Acetal Resin

In the process of the invention one or more chemically different polyvinyl acetal resin may be used as first and polyvinyl acetal resin. Such polyvinyl acetals may differ in polyvinyl alcohol content, degree of acetalisation, residual acetate content, ethylene proportion, molecular weight and/or chain lengths of the aldehyde of the acetal groups.

The polyvinyl acetal resins used in accordance with the invention are produced by reaction of at least one polyvinyl alcohol with one or more aliphatic or aromatic, branched or unbranched compounds with one or more carbonyl functions such as aldehydes and ketones, containing 2 to 10 carbon atoms. To this end, n-butyraldehyde or iso-butyraldehyde are preferably used to obtain n- and/or iso-polyvinylbutyral which are preferentially used in the invention.

The first polyvinyl acetal resins may have a content of polyvinyl acetate groups of 0.1 to 20 mol %, preferably 0.5 to 3 mol %, or 5 to 8 mol %.

The polyvinyl alcohol content of the used polyvinyl acetals may be between 14 - 26 % by weight, 16 - 24 % by weight, 17 - 23 % by weight and preferably between 18 and 21 % by weight.

### Additives

The first and/or second melts may contain alkali metal ion and/or earth alkali metal ion to adjust their adhesion level to glass (so called Anti-Adhesion Additives). The concentrations given below are based on the final film.

The total amount of alkali metal salts may be as low as 0.005 % by weight based on the weight of the interlayer film. Preferred ranges of alkali metal salt are 0.01 % - 0.1 %; 0.02 - 0.08 %; 0.03 - 0.06 %, each weight % based on the weight of the film.

### Plasticizer

The plasticizer content of the melts used in accordance with the invention is not of particular importance and may be adjusted as needed for the mechanical properties of the final film. As the person skilled in the art is aware, the plasticizer content of such films is typically adjusted in a broad range of 0 to 80 % by weight.

However, preferred plasticizer contents of the melts used in accordance with the invention would fall into the ranges of 0 - 16 % by weight, more preferable between 0 and 8 % by weight for plasticizer-reduced films; 14.0 - 45.0 % by weight, preferably 15.0 - 32.0 % by weight and in particular 26.0 - 30.0 % by weight for standard films and 25 - 80 % by weight, preferably 25 - 60 % by weight and in particular 30 to 45 % by weight for sound-damping films.

As plasticiser, one or more compounds selected from the following groups may be used:
- esters of polyvalent aliphatic or aromatic acids, for example dialkyl adipates, such as dihexyl adipate, dioctyl adipate, hexyl cyclohexyl adipate, mixtures of heptyl adipates and nonyl adipates, diisononyl adipate, heptyl nonyl adipate, and esters of adipic acid with cycloaliphatic ester alcohols or ester alcohols containing ether compounds, dialkyl sebacates, such as dibutyl sebacate, and also esters of sebacic acid with cycloaliphatic ester alcohols or ester alcohols containing ether compounds, esters of phthalic acid, such as butyl benzyl phthalate or bis-2-butoxyethyl phthalate.
- esters or ethers of polyvalent aliphatic or aromatic alcohols or oligo ether glycols with one or more unbranched or branched aliphatic or aromatic substituents, for example esters of glycerol, diglycols, triglycols or tetraglycols with linear or branched aliphatic or cycloaliphatic carboxylic acids; Examples of the latter group include diethylene glycol-bis-(2-ethyl hexanoate), triethylene glycol-bis-(2-ethyl hexanoate), triethylene glycol-bis-(2-ethyl butanoate), tetraethylene glycol-bis-n-heptanoate, triethylene glycol-bis-n-heptanoate, triethylene glycol-bis-n-hexanoate, tetraethylene glycol dimethyl ether and/or dipropylene glycol benzoate
- phosphates with aliphatic or aromatic ester alcohols, such as tris(2-ethylhexyl)phosphate (TOF), triethyl phosphate, diphenyl-2-ethylhexyl phosphate, and/or tricresyl phosphate
- esters of citric acid, succinic acid and/or fumaric acid.

Preferable, 1,2-cyclohexane dicarboxylic acid diisononyl ester (DINCH) or triethylene glycol-bis-2-ethyl hexanoate (3GO or 3G8) are used as plasticiser.

In addition, the melts may contain further additives, such as residual quantities of water, UV absorber, antioxidants, adhesion regulators, optical brighteners or fluorescent additives, stabilisers, colorants, processing aids, inorganic or organic nanoparticles, pyrogenic silicic acid and/or surface active substances.

The method according to the invention may be used produce interlayer films for laminated glass and/or adhesion film for photovoltaic modules.

### Lamination Process

The film produced with the method of the present invention is used as interlayer to produce glass laminates

Lamination processes are known to the person skilled in the art. For example, so-called autoclave processes are carried out at an increased pressure from approximately 10 to 15 bar and temperatures from 100 to 150 °C during approximately 2 hours. Vacuum bag or vacuum ring methods (in a sense that no subsequent autoclave treatment is required), for example according to EP 1 235 683 B1, function at approximately 200 mbar and 130 to 145 °C.

Vacuum laminators can also be used for the lamination process. These consist of a chamber that can be heated and evacuated, in which laminated glass can be laminated within 30 - 60 minutes. Reduced pressures from 0.01 to 300 mbar and temperatures from 100 to 200 °C, in particular 130 - 160 °C, have proven their worth in practice.

## Claims

1. Process to extrude a melt stream at 150 - 250°C comprising at least one polyvinyl acetal and at least one plasticizer having a predefined melt viscosity at 60 - 170°C **characterized by**
c) providing a first melt stream comprising at least a first plasticizer and a first polyvinyl acetal resin and measuring online its melt viscosity at 60 - 170°C;
d) adding a crosslinker and/or a molar mass reducing agent to the first melt stream in an amount to provide a second melt stream with a melt viscosity at 60 - 170°C having a difference of at most 20% to the predefined melt viscosity at 60 - 170°C.

2. Process according to claim 1 **characterized in that by** the melt viscosity at 60 - 170°C is measured as melt flow rate MFR, melt volume rate MVR, pressure, shear viscosity, flow rate ratio MFR (weight 1)/ MFR (weight 2), or flow exponent.

3. Process according to claim 1 or 2 **characterized in that** the crosslinker and/or a molar mass reducing agent is added to the first melt stream upstream of the location where step a) is performed.

4. Process according to any of the claims 1 to 3 **characterized in that** the first melt stream is heated to a temperature of 150 - 250°C and a part of the first melt stream is separated and cooled to 60 - 170°C for measuring its melt viscosity at 60 - 170°C.

5. Process according to claim 4, **characterized in that** the crosslinker and/or a molar mass reducing agent is added to the first melt stream upstream of the separation of the part of the first melt stream.

6. Process according to claims 4 or 5 **characterized in that** separated melt stream is combined with the first melt stream after measuring its melt viscosity at 60 - 170°C.

7. Process according to any of the claims 1 to 6 **characterized in that** the crosslinker is an isocyanate.

8. Process according to any of the claims 1 to 7 **characterized in that** the molar mass reducing agent is an oxidizer.

9. Process according to any of the claims 1 to 8 **characterized in that**

10. Process according to any of the claims 1 to 9 **characterized in that** the crosslinker and/or a molar mass reducing agent are added to the first melt stream at a temperature of 150 - 250°C.

11. Process according to any of the claims 1 to 10 **characterized in that** at least two melt streams having different compositions are extruded in contact with each other and wherein at least one melt stream is provided with a predefined melt viscosity at 60 - 170°C according to steps a) and b).

12. Process according to claim 11 **characterized in that** three melt streams are extruded in contact with each other, wherein the outer melt streams are provided with a predefined melt viscosity at 60 - 170°C according to steps a) and b).

13. Process according to claim 11 **characterized in that** three melt streams are extruded in contact with each other, wherein the inner melt stream is provided with a predefined melt viscosity at 60 - 170°C according to steps a) and b).

14. Process according to claim 11 **characterized in that** three melt streams are extruded in contact with each other, wherein the melt streams are provided with the same or different predefined melt viscosity at 60 - 170°C according to steps a) and b).
